Europäisches Patentamt

European Patent Office

Office européen des brevets

(11) Publication number: **0 307 910**
**A2**

## (12) EUROPEAN PATENT APPLICATION

(21) Application number: **88115125.2**

(22) Date of filing: **15.09.88**

(51) Int. Cl.⁴: **H03J 7/18**

(30) Priority: **17.09.87 AU 4409/87**

(43) Date of publication of application:
**22.03.89 Bulletin 89/12**

(84) Designated Contracting States:
**DE FR GB SE**

(71) Applicant: **AMSKAN LIMITED**
**104 Ferntree Gully Road**
**Oakleigh Victoria(AU)**

(72) Inventor: **Nickols, Alan**
**56 Regent Street**
**Oakleigh Victoria(AU)**
Inventor: **Gamgee, Christopher James**
**60 Coorigil Road**
**Carnegie Victoria(AU)**

(74) Representative: **Howden, Christopher Andrew**
**et al**
**FORRESTER & BOEHMERT**
**Widenmayerstrasse 4/I**
**D-8000 München 22(DE)**

(54) **Signal locating apparatus.**

(57) A signal locating apparatus for locating within a frequency band an input signal of a first frequency, the signal locating apparatus including a signal receiver (10) for receiving the input signal. The signal receiver (10) is characterised by having a relatively narrow bandwidth response of variable centre frequency, the signal receiver (10) being capable of generating a detected signal (12) when the centre frequency is substantially equal to the first frequency, the signal locating apparatus further including search means (20) for varying the centre frequency at a relatively high rate so as to cause the signal receiver (10) to search for the presence of the input signal within a frequency band, the search means (20) being operable in response to generation of the detected signal to stop the search for the presence of the input signal. The signal receiver includes an oscillator (13) of variable frequency which determines the centre frequency, a mixer (14) receiving the input signal and operative to generate an intermediate frequency signal (15) and a demodulator (16) connected to receive the intermediate frequency signal (15) and operative to generate the detected signal (12) upon receipt of the intermediate fre-

quency signal (15). The search means (20) includes an integrator (21) connected so as to receive the output signal (12) of the demodulator (16) so that the occurrence of the detected signal (12) at the demodulator output causes an abrupt change in the integrator output.

Fig. 1

# SIGNAL LOCATING APPARATUS

This invention relates to apparatus for locating an input signal within a frequency band. The invention relates particularly to the location of an input signal from a radio transmitter and it will be generally convenient to describe the invention in relation to this particular field of use, however the invention is not limited to this particular type of signal.

The apparatus of the present invention has been developed for use in relation to electronic apparatus for identification of objects including people, animals, and objects e.g. as shown in EP 0108643. Such an identification system includes interrogator means for generating an interrogation signal. The apparatus also includes one or more transponders, each of which includes an interrogation signal receiver for receiving the interrogation signal and operative in response to transmit a radio frequency (RF) reply signal containing coded information to enable identification of the particular transponder and its bearer. The apparatus includes an RF receiver for receiving the reply signal to enable decoding of the information.

In the case of such an identification apparatus, a number of transponders would normally be provided and the apparatus is operative to read data transmitted by the transponders. The transponders may generate the coded information signals within a nominal frequency band, e.g. around 400 MHz. As the transmitter frequency of such transponders is controlled for example by tolerances of the components of the transponder which are relatively inexpensive devices manufactured to low tolerances, there is some variation to be expected in the transmitter frequency. For, example variation up to perhaps 0.5 MHz may be expected.

To enable the receiver to identify signals within a band of frequencies, it is possible to make the receiver in such a way as to have a wideband response. However this reduces the sensitivity of the receiver to low power signals which are likely to be encountered in an identification apparatus having low power transponders.

Because low power transponders should be designed to have a maximum useful life, the transponder should not be designed to transmit information signals for relatively long periods of time in order to ensure that the signal receiver detects and decodes the signal.

It is an object of the present invention to provide a signal locating apparatus for locating an input signal within any frequency band.

A preferred object of the present invention is to provide a signal locating apparatus which can relatively rapidly locate an input signal within a frequency band, but with minimum bandwidth to maximise sensitivity. This will enable a relatively short duration signal of unknown frequency (within a band) to be located.

According to the present invention there is provided a signal locating apparatus for locating an input signal of a first frequency within a frequency band, the signal locating apparatus including a signal receiver for receiving signals in the frequency band including the input signal, the signal receiver being characterised by having a relatively narrow bandwidth response of variable centre frequency, the signal receiver including a detector operative to generate a detected signal on a signal line when the centre frequency is substantially equal to the first frequency, the signal locating apparatus further including search means for varying the centre frequency of the signal receiver at a relatively high rate so as to cause the signal receiver to search for the presence of the input signal within the frequency band, the search means including an integrator operative to generate an integrator output signal, the integrator output signal having a varying characteristic after the application of an initialisation signal thereto and in the absence of the detected signal, the signal receiver being responsive to the varying integrator output signal to vary the centre frequency thereof, the signal receiver being operable in response to occurrence of the detected signal on the signal line to stop the variation in the integrator output signal and hence stop the variation of the centre frequency and hence stop the search for the presence of the input signal.

Possible and preferred features of the present invention are illustrated in the accompanying drawings. However, it is to be understood that the features illustrated in and described with reference to the drawings are not to be construed as limiting on the scope of the invention.

Fig. 1 shows a block schematic diagram of a signal locating apparatus according to one possible embodiment of the present invention, and

Fig. 2 shows typical waveforms for the demodulator and integrator outputs.

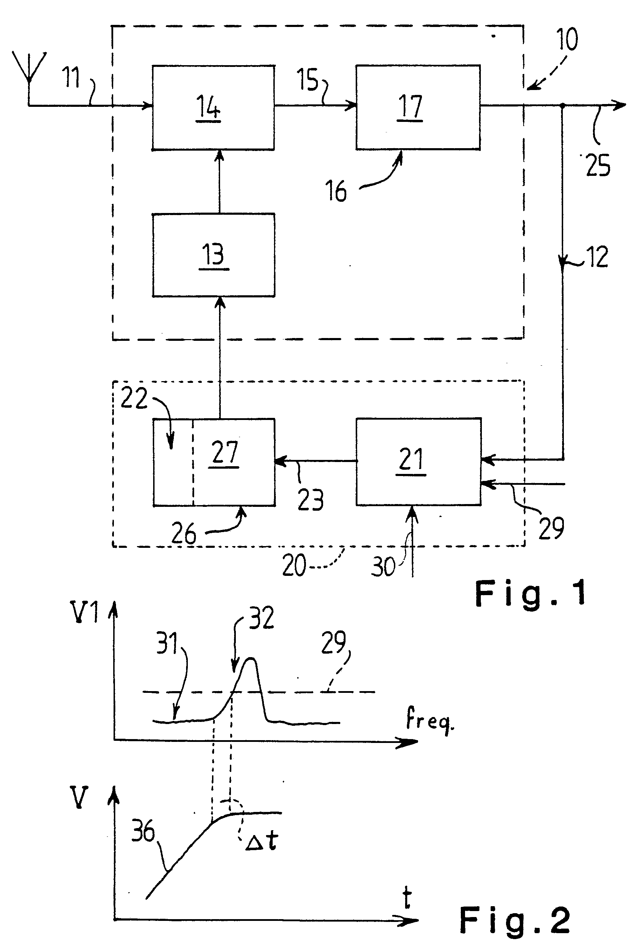

The signal locating apparatus illustrated in Fig. 1 is for locating within a frequency band an input signal of a first frequency. The apparatus includes a signal receiver 10 for receiving an input 11 within the frequency band and which includes the input signal sought, the signal receiver 10 having a relatively narrow bandwidth response of variable centre frequency. The first part of Fig. 2 shows the signal receiver output if the centre frequency is swept through the entire band. The signal receiver 10 generates a detected signal 32 (Fig. 2) when the centre frequency is substantially equal to the first frequency. The signal locating apparatus also includes search means 20 for varying the centre frequency at a relatively high rate so as to cause the signal receiver 10 to search for the presence of the input signal within a frequency band, the search means 20 being operable in response to generation of the detected signal 32 to stop the search for the presence of the input signal. In particular the search means 20 stops varying the centre frequency in response to generation of the detected signal 32.

The signal receiver 10 includes an oscillator 13 of variable frequency which determines the centre frequency. The signal receiver 10 further includes a mixer 14 receiving the input 11 and operative to generate an intermediate frequency (IF) signal 15 if the oscillator frequency is correctly offset from the input signal frequency. The IF signal 15 is then applied to a demodulator 16 (or FM detector), the demodulator 16 generating the detected signal 32 upon receipt of the IF signal 15. If the input signal is absent, the input 11 comprises a background noise signal which is input to the demodulator 16 and this in turn produces at the output of the demodulator 16 a signal 31 (Fig. 2) related to the noise level, this output for example being a voltage level.

The search means 20 is operable to vary the oscillator frequency in order to control the centre frequency. The search means 20 is operable to cause the oscillator frequency to continuously vary from one extreme of the frequency band towards the other. For example, the oscillator 13 may be caused to scan for an input frequency from 399.5 MHz towards 400.5 MHz.

The search means 20 includes an integrator 21 which controls scanning of the centre frequency of the signal receiver 10, the integrator 21 being connected to demodulator output line 12 so that the occurrence of the detected signal 32 on the demodulator output line 12, after an initialisation signal 30 is applied to the integrator 21 at the beginning of the sweep or scan of the frequency band, causes an abrupt change in the integrator output (Fig. 2). If the receiver centre frequency is not equal to the first frequency, the output of the demodulator 16 is a first voltage level 31 resulting from background signal noise, this voltage level 31 at the output of the demodulator 16 being applied to the integrator 21 which in turn provides an output ramp 36 on line 23 signal 23 which is used to control sweeping or scanning of the oscillator frequency. This is achieved by applying a reference voltage 29 related to an expected or predetermined level of the detected signal 32. The integrator 21 determines the function:

$$\int (V1 - Vref) \, dt$$

where V1 is the level of the demodulator output 31 and Vref is the level of the reference voltage 29. The value of this function, and hence the output signal 36 ceases to ramp as shown in the lower part of Fig. 2 when the detected signal 32 reaches the level of the reference signal 29. This stops the sweeping or scanning of the centre frequency of the receiver 10. Up to the time that the detected signal 32 appears, the integrator output signal 36 is a ramp which causes continuous scanning of the centre frequency. When the integrator output signal 36 stops ramping this can then effectively "lock" the oscillator frequency to the desired first frequency. Any "overshoot" of the centre frequency causes a reversal of the integrator output 36 which will reduce the centre frequency back to the input first frequency. The demodulator output signal 31 can be passed to output 25 for enabling processing, such as extraction of coded information.

The signal locating apparatus in one possible embodiment has an integrator 21 which has a selectively variable time constant so as to be operable as a sweep rate controller operable in response to an initial indication of the presence of the detected signal 32 to vary the time constant of the integrator 21 so as to reduce the ramp rate and hence reduce the rate of search. That is, in response to commencement of the detected signal 32, the rate of sweeping of the oscillator frequency is reduced to provide slower more precise "locking" of the signal receiver centre frequency to the first frequency. This can occur in response to the rise of the demodulator output 31 during time interval Δt as shown in Fig. 2.

The signal locating apparatus further includes frequency logging means 22 operable preferably before an input signal locating operation is carried out (although possibly after such an operation) to scan the frequency range and log the background signal data. In this embodiment the apparatus further includes background compensating means 25 operable during the input locating operation to use the logged background signal data to compensate for background signal effects and reduce the chance of a spurious background signal being detected and identified as the input signal sought.

Preferably the frequency logging operation is initiated substantially immediately before a time window within which an input signal is to be expected and identified. For example in an object identification apparatus, an interrogation signal may be generated and directed towards a transponder which responds after a known predetermined delay period. In this environment, the logging operating is preferably carried out immediately before the response time window of the transponder.

The frequency logging means 22 and background compensating means 23 may be comprised by a microprocessor 27. The microprocessor 27 is arranged to be responsive to the output 36 of the integrator 21 and controls the scan rate of the oscillator 13. During the logging operation the microprocessor 27 monitors and stores in memory the output 36 of the integrator ˚1. During the input signal search operation, the microprocessor 27 is operative to continuously compare the integrator output 36 to the logging operation data in memory to thereby enable an increase in selectivity of the apparatus to a genuine input singal and reduce the risk of a background signal (e.g. from some RF source nearby) being identified as the input signal sought.

It will be seen that the preferred embodiment of the signal locating apparatus described herein and illustrated in the drawing will relatively quickly scan through a frequency band within which an input signal of a relatively constant but unknown frequency is to be encountered. Thus the sensitivity of the system within which the apparatus is incorporated can be relatively high by enabling a specific frequency to be locked onto. This also enables the system to be used with relatively low power input signals. These features make the signal locating apparatus particularly suitable for use with inexpensive transponders used in an object identification system.

The features disclosed in the foregoing description, in the claims and/or in the accompanying drawings may, both separately and in any combination thereof, be material for realising the invention in diverse forms thereof.

## Claims

1. A signal locating apparatus for locating an input signal of a first frequency within a frequency band, the signal locating apparatus including a signal receiver (10) for receiving signals in the frequency band including the input signal, the signal receiver (10) being characterised by having a relatively narrow bandwidth response of variable centre frequency, the signal receiver (10) including a detector (16) operative to generate a detected signal (32) on a signal line (12) when the centre frequency is substantially equal to the first frequency, the signal locating apparatus further including search means (20) for varying the centre frequency of the signal receiver (10) at a relatively high rate so as to cause the signal receiver (10) to search for the presence of the input signal within the frequency band, the search means (20) including an integrator (21) operative to generate an integrator output signal (36), the integrator output signal (36) having a varying characteristic after the application of an initialisation signal (30) thereto and in the absence of the detected signal (32), the signal receiver (10) being responsive to the varying integrator output signal (36) to vary the centre frequency thereof, the signal receiver (10) being operable in response to occurrence of the detected signal (32) on the signal line (12) to stop the variation in the integrator output signal (36) and hence stop the variation of the centre frequency and hence stop the search for the presence of the input signal.

2. A signal locating apparatus as claimed in Claim 1 characterised in that, if the receiver centre frequency is not equal to the first frequency, the output of the detector (16) on the signal line (12) comprises a first voltage level which is applied to the integrator (21) so that the integrator output signal (36) comprises a ramp signal which is used to control sweeping or scanning of the centre frequency of the signal receiver (10).

3. A signal locating apparatus as claimed in Claim 2 characterised in that the integrator (21) receives a reference signal (29) related to a level of the detected signal (32), and the integrator output signal (36) ceases to ramp when the detected signal reaches the level of the reference signal (29) hence stopping sweeping or scanning of the centre frequency of the signal receiver (10).

4. A signal locating apparatus as claimed in any one of Claims 1 to 3 characterised in that the integrator (21) has a variable time constant so as to be operable as a sweep rate controller, the integrator (21) being operative in response to an initial indication of the presence of the detected signal (32) to vary the time constant of the integrator (21) so as to reduce the ramp rate and hence reduce the rate of change of the centre frequency.

5. A signal locating apparatus as claimed in any one of the preceding claims and further characterised by frequency logging means (22) operable to scan the frequency band and to log the background signal data, the signal locating apparatus further including background compensating means (26) operable, during an operation of the apparatus for the purpose of locating an input signal, to use the logged background signal data to compensate for background signal effects and reduce the chance of a spurious background signal being detected and identified as the input signal sought.

6. A signal locating apparatus as claimed in Claim 5 characterised in that the apparatus is associated with a transponder which responds to an interrogation signal after a predetermined delay period, the frequency logging means (22) being operable substantially immediately before a time window occurring after said delay period.

7. A signal locating apparatus as claimed in claim 6 characterised in that the frequency logging means (22) and background compensating means (26) are comprised by a processor (27) connected and operative in response to the output (23) of the integrator (21), the processor (27) controlling in use the scan rate of the signal receiver (10), the processor (27) being operative during a background logging operation to monitor and store in a memory the output of the integrator (21), the processor (27) being operative during an operation of the apparatus to search for the presence of an input signal to compare the integrator output (23) to the logging operation data in memory so as to thereby enable an increase in selectivity of the apparatus to a genuine input signal and reduce the risk of a background signal being identified as the input signal sought.

8. A signal locating apparatus as claimed in any one of the preceding claims characterised in that the signal receiver includes an oscillator (13) of variable frequency which determines the centre frequency, the signal receiver (10) further including a mixer (14) receiving the signals in the frequency band including the input signal and operative to generate an intermediate frequency signal (15) if the oscillator frequency has a predetermined relationship to the input signal frequency, the detector (16) comprising a demodulator (16) connected to receive the intermediate frequency signal (15) and operative to generate the detected signal (32) upon receipt of the intermediate frequency signal (15).

9. A signal locating apparatus as claimed in Claim 8 characterised in that if the input signal is absent, a background noise signal is input to the demodulator (17), the demodulator (17) as a result producing a noise related signal output (31) related to the background noise signal level.

10. A signal locating apparatus as claimed in Claim 8 or 9 characterised in that the oscillator frequency is variable under the control of the integrator (21) so as to cause the frequency of the oscillator (13) to continuously vary from one extreme of the frequency band towards the other.

Fig. 1

Fig. 2